# EUROPEAN PATENT SPECIFICATION

(11) **EP 1 821 570 B1**
(45) Date of publication and mention of the grant of the patent: **08.02.2017**
(21) Application number: 07002957.4
(22) Date of filing: 22.10.2001
(51) Int. Cl.: B81B 7/00, H04R 19/01

(54) **Miniature silicon condenser microphone and method for producing same**
Miniatursiliciumkondensatormikrofon und Herstellungsverfahren dafür
Microphone de condensateur en silicone miniature et son procédé de production

(30) Priority: 28.11.2000 US 253543 P; 21.06.2001 US 886854
(43) Date of publication of application: 22.08.2007
(62) Divisional of application: 01990255.0
(73) Proprietor: Knowles Electronics, LLC, Itasca, Illinois 60143 (US)
(72) Inventor: Minervini, Anthony, D., Palos Hills, IL 60465 (US)
(74) Representative: Wynne-Jones, Laine and James LLP

(56) References cited:
- EP-A- 0 774 888
- FI-A- 981 413
- US-A- 4 533 795
- US-A- 5 592 391
- PATENT ABSTRACTS OF JAPAN vol. 1997, no. 08, 29 August 1997 (1997-08-29) & JP 09 107192 A (KITAGAWA IND CO LTD), 22 April 1997 (1997-04-22)

## Description

### Technical Field

The present invention relates generally to a housing for a transducer. More particularly, this invention relates to a miniature silicon condenser microphone comprising a housing for shielding a transducer produced on the surface of a silicon die. The silicon die must be packaged to produce a functional microphone of this type.

### Related Application

This Application claims the benefit of Provisional Patent Application Serial No. 60/253,543 filed November 28, 2000.

### Background of the Invention

There have been a number of disclosures related to building microphone elements on the surface of a silicon die. Certain of these disclosures have come in connection with the hearing aid field for the purpose of reducing the size of the hearing aid unit. While these disclosures have reduced the size of the hearing aid, they have not disclosed how to protect the transducer from outside interferences. For instance, transducers of this type are fragile and susceptible to physical damage. Furthermore, they must be protected from light and electromagnetic interferences. Moreover, they require an acoustic pressure reference to function properly. For these reasons, the silicon die must be shielded.

Some shielding practices have been used to house these devices. For instance, insulated metal cans or discs have been provided. Additionally, DIPs and small outline integrated circuit (SOIC) packages have been utilized. However, the drawbacks associated with manufacturing these housings, such as lead time, cost, and tooling, make these options undesirable.

US-A-4 533 795 defines an electroacoustic transDucer in the form of a capacitive microphone for incorporation in to a semi-conductor substrate.

### Summary of the Invention

The present invention is as set OUt in claim 1.

Other features and advantages of the invention will be apparent from the following specification taken in conjunction with the following drawings.

### Brief Description of the Drawings

Figure 1 is a cross-sectional view of a first embodiment of a silicon condenser microphone of the present invention;
Figure 2 is a cross-sectional view of a second embodiment of a silicon condenser microphone of the present invention;
Figure 3 is a cross-sectional view of a third embodiment of a silicon condenser microphone of the present invention;
Figure 4 is a cross-sectional view of the third embodiment of the present invention affixed to an end user circuit board;
Figure 5 is a cross-sectional view of the third embodiment of the present invention affixed to an end user circuit board in an alternate fashion; and
Figure 6 is a plan view of a substrate to which a silicon condenser microphone is fixed;
Figure 7 is a longitudinal cross-sectional view of a microphone package of the present invention;
Figure 8 is a lateral cross-sectional view of a microphone package of the present invention;
Figure 9 is a longitudinal cross-sectional view of a microphone package of the present invention;
Figure 10 is a lateral cross-sectional view of a microphone package of the present invention;
Figure 11 is a cross-sectional view of a top portion for a microphone package of the present invention;
Figure 12 is a cross-sectional view of a top portion for a microphone package of the present invention;
Figure 13 is a cross-sectional view of a top portion for a microphone package of the present invention;
Figure 14a is a cross-sectional view of a laminated bottom portion of a housing for a microphone package of the present invention;
Figure 14b is a plan view of a layer of the laminated bottom portion of Figure 14a;
Figure 14c is a plan view of a layer of the laminated bottom portion of Figure 14a;
Figure 14d is a plan view of a layer of the laminated bottom portion of Figure 14a;
Figure 15 is a cross-sectional view of a bottom portion for a microphone package of the present invention;
Figure 16 is a cross-sectional view of a bottom portion for a microphone package of the present invention;
Figure 17 is a cross-sectional view of a bottom portion for a microphone package of the present invention;
Figure 18 is a cross-sectional view of a bottom portion for a microphone package of the present invention;
Figure 19 is a plan view of a side portion for a microphone package of the present invention;
Figure 20 is a cross-sectional view of a side portion for a microphone package of the present invention;
Figure 21 is a cross-sectional view of a side portion for a microphone package of the present invention;
Figure 22 is a cross-sectional view of a side portion for a microphone package of the present invention;
Figure 23 is a cross-sectional view of a microphone package of the present invention;
Figure 24 is a cross-sectional view of a microphone package of the present invention;
Figure 25 is a cross-sectional view of a microphone package of the present invention;
Figure 26 is a cross-sectional view of a microphone package of the present invention;
Figure 27 is a cross-sectional view of a microphone package of the present invention with a retaining ring;
Figure 28 is a cross-sectional view of a microphone package of the present invention with a retaining wing; and
Figure 29 is a cross-sectional view of a microphone package of the present invention with a retaining ring.

### Detailed Description of the Preferred Embodiments

While this invention is susceptible of embodiments in many different forms, there is shown in the drawings and will herein be described in detail preferred embodiments of the invention with the understanding that the present disclosure is to be considered as an exemplification of the principles of the invention and is not intended to limit the broad aspect of the invention to the embodiments illustrated.

The present invention is directed to microphone packages. The benefits of the microphone packages disclosed herein over microphone packaging utilizing plastic body/lead frames include the ability to process packages in panel form allowing more units to be formed per operation and at much lower cost. The typical lead frame for a similarly functioning package would contain between 40 and 100 devices connectedtogether. The present disclosure would have approximately 14,000 devices connected together (as a panel). Also, the embodiments disclosed herein require minimal "hard-tooling." This allows the process to adjust to custom layout requirements without having to redesign mold, lead frame, and trim/form tooling.

Moreover, these embodiments have a better match of thermal coefficients of expansion with the end user's PCB since this part would typically be mounted of FR-4 which is the same material used by end users. The present designs may also eliminate the need for wire bonding that is required in plastic body/lead frame packages. The foot print is typically smaller than that would be required for a plastic body/lead frame design since the leads are formed by plating a through-hole in a circuit board of which one half will eventually form the pathway to the solder pad. In a typical plastic body/lead frame design, a gull wing configuration would be used in which the leads widen the overall foot print.

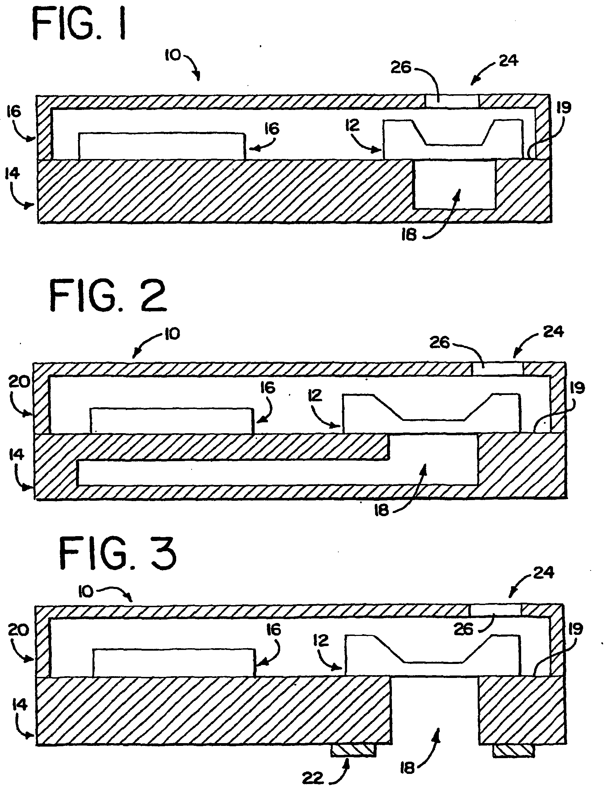

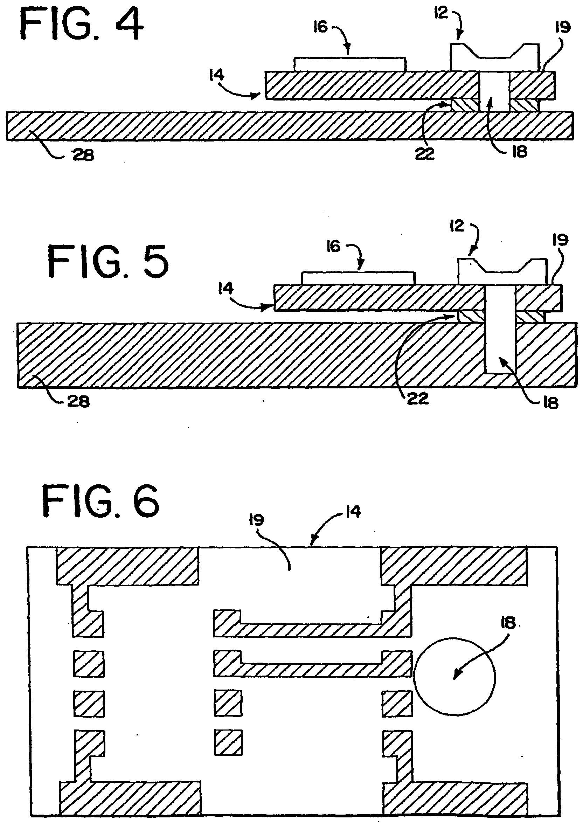

Now, referring to Figures 1-3, three embodiments of a silicon condenser microphone package 10 of the present invention are illustrated. The silicon microphone package 10 of the present invention generally comprises a transducer 12, e.g. a silicon condenser microphone as disclosed in U.S. Patent No. 5,870,482, a substrate 14, an amplifier 16, aback volume or air cavity 18 which provides a pressure reference for the transducer 12, and a cover 20. The substrate 14 is typically formed of FR-4 material which may be processed in circuit board panel form, thus taking advantage of economies of scale in manufacturing. Figure 6 is a plan view of the substrate 14 showing the back volume 18 surrounded a plurality of terminal pads.

The back volume 18 may be formed by a number of methods, including controlled depth drilling of an upper surface 19 of the substrate 14 to form a recess over which the silicon condenser microphone is mounted (Figure 1); drilling and routing of several individual sheets of FR-4 and laminating the individual sheets to form the back volume 18 which may or may not have internal support posts (Figure 2); or drilling completely through the substrate 14 and providing a sealing ring 22 on the bottom of the device that will seal the back volume 18 during surface mounting to a user's "board" 28 (Figures 3-5). In this example, the combination of the substrate and the user's board 28 creates the back volume 18. The back volume 18 is covered by the transducer 12 (MEMS device) which is "bumpbonded" and mounted face down. The boundary is sealed such that the back volume 18 is "air-tight".

The cover 20 is attached for protection and processibility. The cover 20 contains an aperture 24 which may contain a sintered metal insert 26 to prevent water, particles and/or light from entering the package and damaging the internal components inside; i.e. semiconductor chips. The aperture 24 is adapted for allowing sound waves to reach the transducer 12.

Referring to Figures 4 and 5, the final form of the product (shown without the cover 20) is a silicon condenser microphone package 10 which would most likely be attached to a end user's PCB 28 via a solder reflow process. Figure 5 illustrates a method of enlarging the back volume 18 by including a chamber 32 within the end user's circuit board 28.

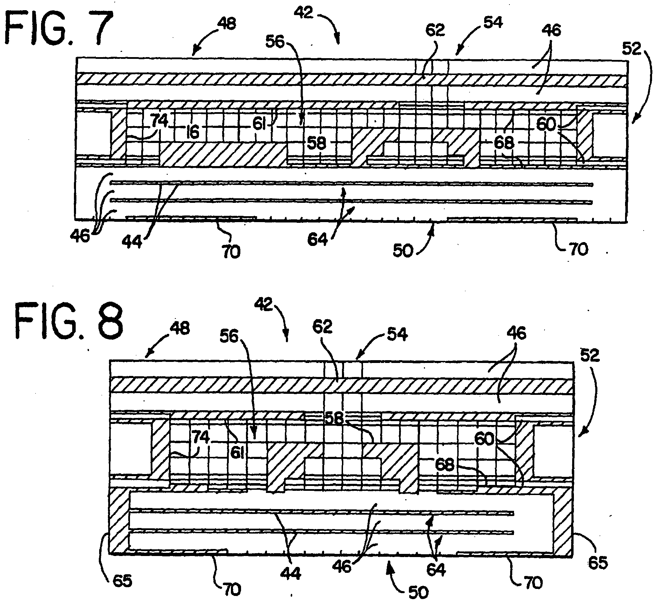

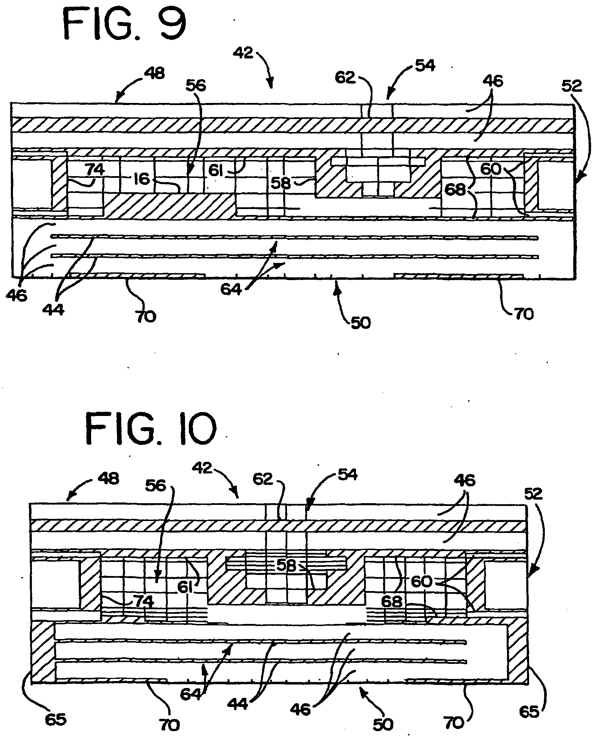

Another embodiment ofa silicon condenser microphone package 40 of the present invention is illustrated in Figures 7-10. In this embodiment, a housing 42 is formed from layers of materials, such as those used in providing circuit boards. Accordingly, the housing 42 generally comprises alternating layers of conductive and non-conductive materials 44, 46. The non-conductive layers 46 are typically FR-4 board. The conductive layers 44 are typically copper.

In the embodiment illustrated, the housing 42 includes a top portion 48 and a bottom portion 50 spaced by a side portion 52. The housing 42 further includes an aperture or acoustic port 54 for receiving an acoustic signal and an inner chamber 56 which is adapted for housing a transducer unit 58, typically a silicon die microphone or a ball grid array package (BGA). The top, bottom, and side portions 48, 50, 52 are electrically connected, for example with a conductive adhesive 60. Each portion may comprise alternating conductive and non-conductive layers of 44, 46.

The chamber 56 includes an inner lining 61. The inner lining 61 is primarily formed by conductive material. It should be understood that the inner lining may include portions of non-conductive material, as the conductive material may not fully cover the non-conductive material. The inner lining 61 protects the transducer 58 against electromagnetic interference and the like, much like a faraday cage.

In the various embodiments illustrated in Figures 7-10 and 23-26, the portions of the housing 42 that include the aperture or acoustic port 54 further include a layer of material that forms an environmental barrier 62 over or within the aperture 54. This environmental barrier 62 is typically a polymeric material formed to a film, such as a polytetrafluoroethylene (PTFE) or a sintered metal. The environmental barrier 62 is supplied for protecting the chamber 56 of the housing 42, and, consequently, the transducer unit 58 within the housing 42, from environmental elements such as sunlight, moisture, oil, dirt, and/or dust

The environmental barrier layer 62 is generally sealed between two layers of conductive material 44. When the environmental barrier layer 62 is sandwiched between two layers of conductive material 44, it may act as a capacitor (with electrodes defined by the metal) that can be used to filter input and output signals or the input power. The environmental barrier layer 62 may further serve as a dielectric protective layer when in contact with the conductive layers 44 in the event that the conductive layers also contain thin film passive devices such as resistors and capacitors.

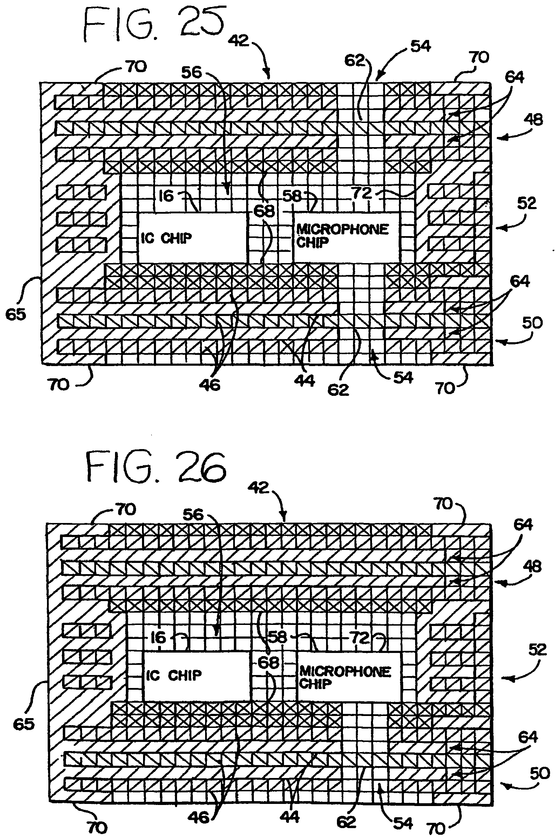

In addition to protecting the chamber 56 from environmental elements, the barrier layer 62 allows subsequent wet processing, board washing of the external portions of the housing 42, and electrical connection to ground from the walls via thru hole plating. The environmental barrier layer 62 also allows the order of manufacturing steps in the fabrication of the printed circuit board-based package to be modified. This advantage can be used to accommodate different termination styles. For example, a double sided package can be fabricated having a pair of apertures 54 (see Figure 25), both including an environmental barrier layer 62. The package would look and act the same whether it is mounted face up or face down, or the package could be mounted to provide directional microphone characteristics.

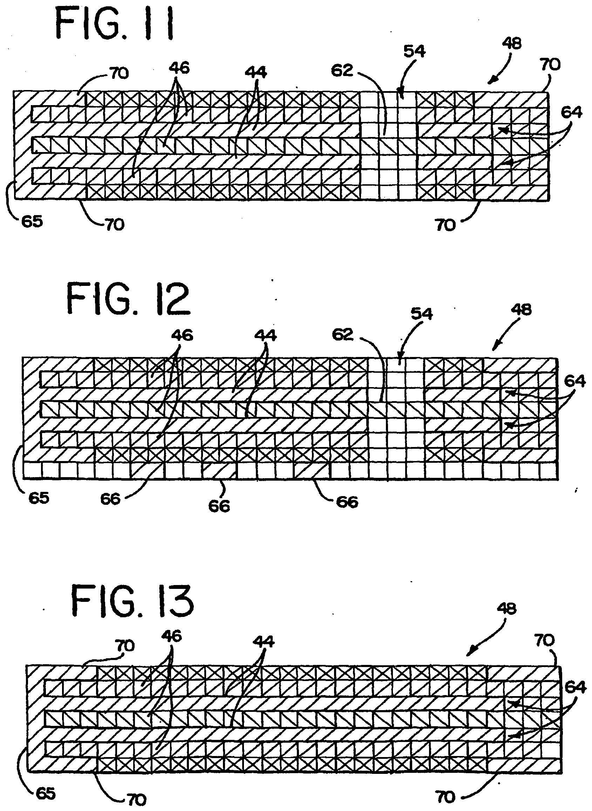

Referring to Figures 7,8, and 11-13, the transducer unit 58 is generally not mounted to the top portion 48 of the housing. This definition is independent of the final mounting orientation to an end user's circuit board. It is possible for the top portion 48 to be mounted face down depending on the orientation of the transducer 58 as well as the choice for the bottom portion 50. The conductive layers 44 of the top portion 48 may be patterned to form circuitry, ground planes, solder pads, ground pads, and plated through hole pads. Referring to Figures 11-13, there may be additional alternating conductive layers 44, non-conductive layers 46, and environmental protective membranes 62 as the package requires. Alternatively, some layers may be deliberately excluded as well. The first non-conductive layer 46 may be patterned so as to selectively expose certain features on the first conductive layer 44.

Figure 11 illustrates an alternative top portion 48 for a microphone package. In this embodiment, a connection between the layers can be formed to provide a conduit to ground. The top portion of Figure 11 includes ground planes and/or pattern circuitry 64 and the environmental barrier 62. The ground planes and or pattern circuitry 64 are connected by pins 65.

Figure 12 illustrates another embodiment of a top portion 48. In addition to the connection between layers, ground planes/pattern circuitry 64, and the environmental barrier 62, this embodiment includes conductive bumps 66 (e.g. Pb/Sn or Ni/Au) patterned on the bottom side to allow secondary electrical contact to the transducer 58. Here, conductive circuitry would be patterned such that electrical connection between the bumps 66 and a plated through hole termination is made.

Figure 13 illustrates yet another embodiment of the top portion 48. In this embodiment, the top portion 48 does not include an aperture or acoustic port 54.

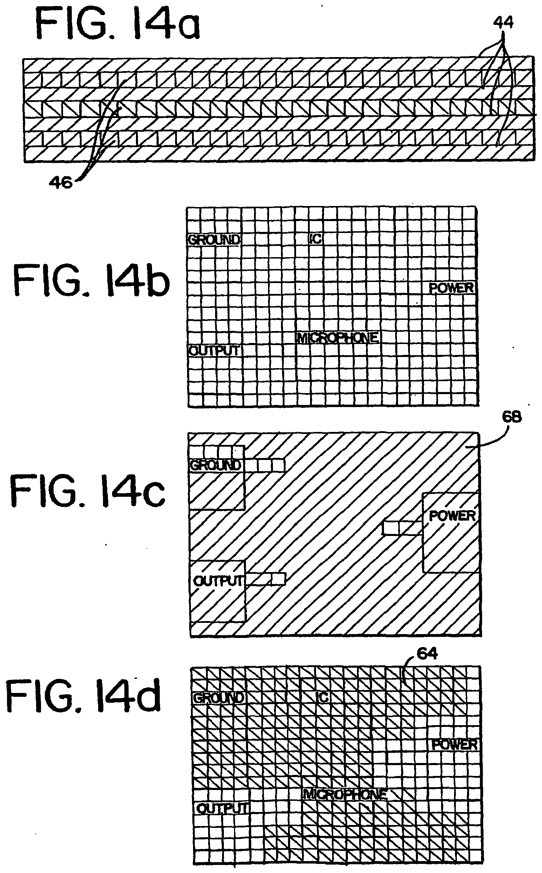

Referring to Figures 7, 8 and 14-18, the bottom portion 50 is the component of the package to which the transducer 58 is primarily mounted. This definition is independent of the final mounting orientation to the end user's circuit board. It is possible for the bottom portion 50 to be mounted facing upwardly depending on the mounting orientation of the transducer 58 as well as the choice for the top portion 48 construction. Like the top portion 48, the conductive layers 44 of the bottom portion 50 may be patterned to form circuitry, ground planes, solder pads, ground pads and plated through hole pads. As shown in Figures 14-18, there may be additional alternating conductive layers 44, non-conductive layers 46, and environmental protective membranes 62 as the package requires. Alternatively, some layers may be deliberately excluded as well. The first non-conductive layer 46 may be patterned so as to selectively expose certain features on the first conductive layer 44.

Referring to Figures 14a through 14d, the bottom portion 50 comprises a laminated, multi-layered board including layers of conductive material 44 deposited on layers of non-conductive material 46. Referring to Figure 14b, the first layer of conductive material is used to attach wire bonds or flip chip bonds. This layer includes etched portions to define lead pads, bond pads, and ground pads. The pads would have holes drilled through them to allow the formation of plated through-holes.

As shown in Figure 14c, a dry film 68 of non-conductive material covers the conductive material. This illustration shows the exposed bonding pads as well as an exposed ground pad. The exposed ground pad would come in electrical contact with the conductive epoxy and form the conenction to ground of the side portion 52 and the base portion 50.

Referring to Figure 14d, ground layers can be embedded within the base portion 50. The hatched area represents a typical ground plane 64. The ground planes do not overlap the power or output pads, but will overlap the transducer 58.

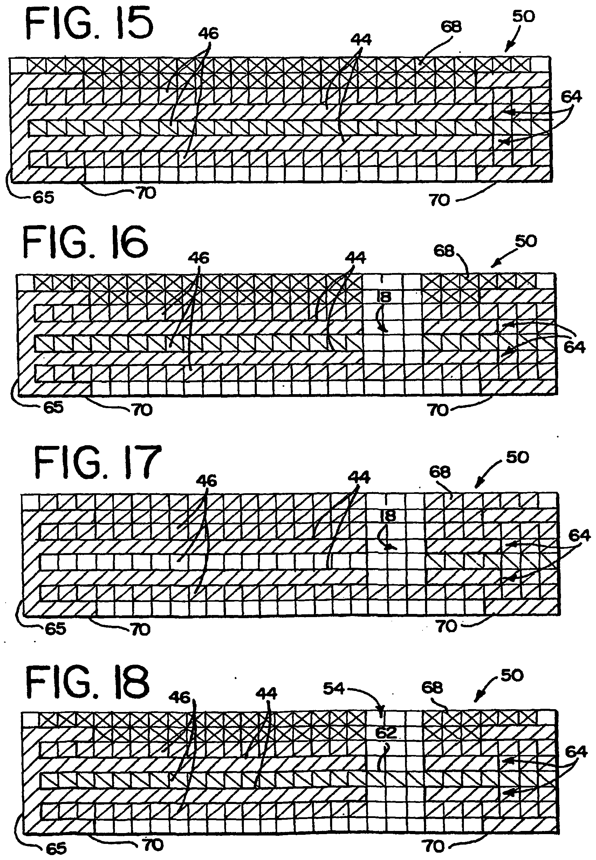

Referring to Figure 15, an embodiment of the bottom portion 50 is illustrated. The bottom portion 50 of this embodiment includes a solder mask layer 68 and alternating layers of conductive and non-conductive material 44, 46. The bottom portion further comprises solder pads 70 for electrical connection to an end user's board.

Figures 16 and 17 illustrate embodiments of the bottom portion 50 with enlarged back volumes 18. These embodiments illustrate formation of the back volume 18 using the conductive/non-conductive layering.

Figure 18 shows yet another embodiment of the bottom portion 50. In this embodiment, the back portion 50 includes the acoustic port 54 and the environmental barrier 62.

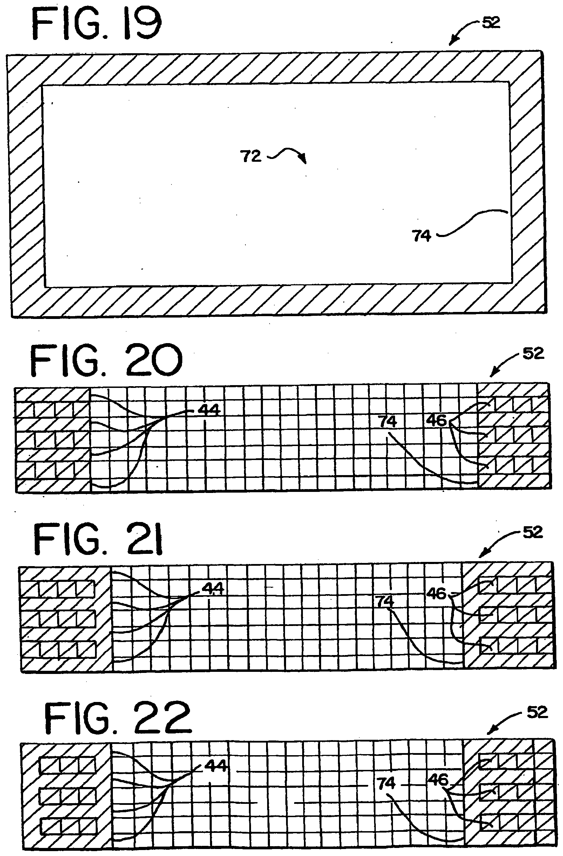

Referring to Figure 7-10 and 19-22, the side portion 52 is the component of the package that joins the bottom portion 50 and the top portion 48. The side portion 51 may include a single layer of a non-conductive material 46 sandwiched between two layers of conductive material 44. The side portion 48 forms the internal height of the chamber 56 that houses the transducer 58. The side portion 52 is generally formed by one or more layers of circuit board material, each having a routed window 72 (see Figure 19).

Referring to Figures 19-22, the side portion 52 includes inner sidewalls 74. The inner side walls 74 are generally plated with a conductive material, typically copper, as shown in Figures 20 and 21. The sidewalls 74 are formed by the outer perimeter of the routed window 72 and coated/metallized with a conductive material.

Alternatively, the sidewalls 74 may be formed by many alternating layers of non-conductive material 46 and conductive material 44, each having a routed window 72 (see Figure 19). In this case, the outer perimeter of the window 72 may not require coverage with a conductive material because the layers of conductive material 44 would provide effective shielding.

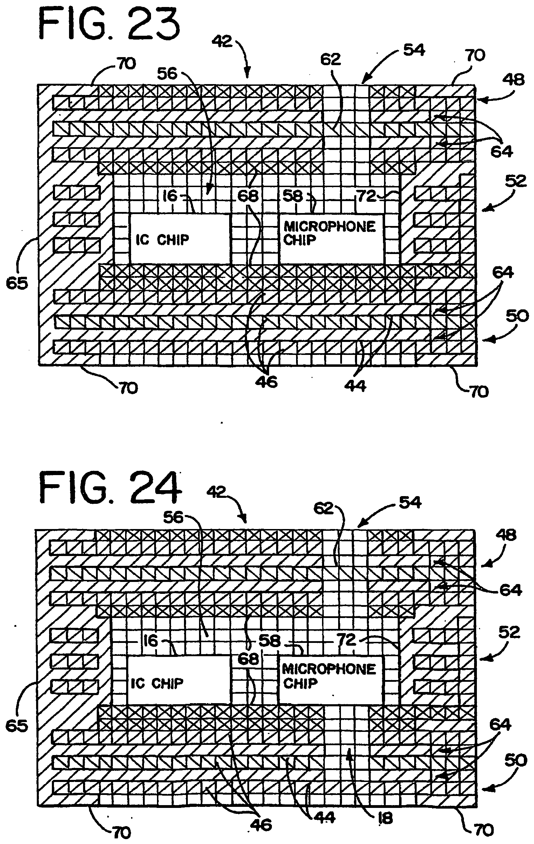

Figures 23-26 illustrate various embodiments of the microphone package 40. These embodiments utilize top, bottom, and side portions 48, 50, and 52 which are described above. It is contemplated that each of the top, bottom, and side portion 48, 50, 52 embodiments described above can be utilized in any combination without departing from the invention disclosed and described herein.

In Figure 23, connection to an end user's board is made through the bottom portion 50. The package mounting orientation is bottom portion 50 down Connection from the transducer 58 to the plated through holes is be made by wire bonding. The transducer back volume 18 is formed by the back hole (mounted down) of the silicon microphone only. Bond pads, wire bonds and traces to the terminals are not shown. A person ordinary skilled in the art of PCB design will understand that the traces reside on the first conductor layer 44. The wire bonds from the transducer 58 are be connected to exposed pads. The pads are connected to the solder pads via plated through holes and traces on the surface.

In Figure 24, connection to the end user's board is also made through the bottom portion 50. Again, the package mounting orientation is bottom portion 50 Connection from the transducer 58 to the plated through holes are made by wire bonding. The back volume 18 is formed by a combination of the back hole of the transducer 58 (mounted down) and the bottom portion 50.

In Figure 25, connection to the end user's board is also made through the bottom portion 50. Again, the package mounting orientation is bottom portion 50 Connection from the transducer 58 to the plated through holes are made by wire bonding. With acoustic ports 54 on both sides of the package, there is no back volume, This method is suitable to a directional microphone.

In Figure 26, connection to the end user's board is made through the top portion 48 of the bottom portion 50. The package mounting orientation is either top portion 48 down or bottom portion 50 down. Connection from the transducer 58 to the plated through holes is made by flip chipping and trace routing. The back volume 18 is formed by using the air cavity created by laminating the bottom portion 50 and the top portion 48 together. Some portion of the package fabrication is performed after the transducer 58 has been attached. In particular, the through hole formation, plating, and solder pad definition would be done after the transducer 58 is attached. The protective membrane 62 is hydrophobic and prevent corrosive plating chemistry from entering the chamber 56.

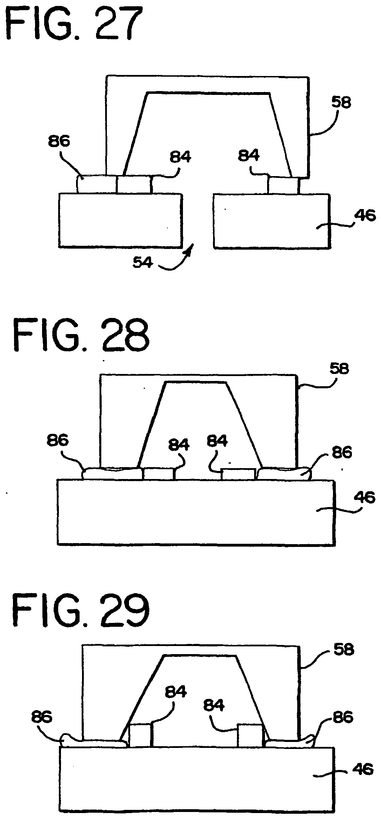

Referring to Figures 27-29, the portion to which the transducer unit 58 is mounted may include a retaining ring 84. The retaining ring 84 prevents wicking of an epoxy 86 into the transducer 58 and from flowing into the acoustic port or aperture 54. Accordingly, the shape of the retaining ring 84 will typically match the shape of the transducer 58 foot print The retaining ring 84 comprises a conductive material (e.g., 3 mil. thick copper) imaged on a non-conductive layer material.

Referring to Figure 27, the retaining ring 84 is imaged onto a non-conductive layer. An epoxy is applied outside the perimeter of the retaining ring 84, and the transducer 58 is added so that it overlaps the epoxy 86 and the retaining ring 84. This reduces epoxy 86 wicking up the sides of the transducer's 58 etched port (in the case of a silicon die microphone).

Alternatively, referring to Figure 28, the retaining ring 84 can be located so that the transducer 58 does not contact the retaining ring 84. In this embodiment, the retaining ring 84 is slightly smaller than the foot print of the transducer 58 so that the epoxy 86 has a restricted path and is, thus, less likely to wick. In Figure 29, the retaining ring 84 is fabricated so that it contacts the etched port of the transducer 58.

The following tables provide an illustrative example of a typical circuit board processing technique for fabrication of the housing of this embodiment.

**Table 1: Materials**

| Material | Type | Component | Note |
|---|---|---|---|
| 1 | 0.5/0.5 oz. DST | Bottom Portion (Conductive | |
| | Cu 5 core FR-4 | Layers 1 and 2; Non-Conductive Layer 1) | |
| 2 | 0.5/0.5 oz. DST | Bottom Portion (Conductive | |
| | Cu 5 core FR-4 | Layers 3 and 4; Non-Conductive Layer 2) | |
| 3 | 106 pre-preg | | For Laminating Material 1 and Material 2 |
| 4 | 0.5/0.5 oz. DST | Side Portion | Metallized Afterward |
| | Cu 40 Core FR-4 | | |
| 5 | Bare/0.5 oz Cu 2 core FR-4 (2 pieces) | Top Portion (Each Piece Includes 1 Conductive and 1 Non-Conductive Layer) | |
| 6 | Expanded PTFE Environmental Barrier | | |

**Table 2: Processing of Materials (Base Portion Material 1)**

| Step | Type | Description | Note |
|---|---|---|---|
| 1 | Dry Film Conductive Layers | | |
| 2 | Expose | Mask Material 1 (Lower Conductive Layer) | Forms Ground Plane on Lower Conductive Layer |
| 3 | Develop | | |
| 4 | Etch Cu | | No Etching on Upper Conductive Layer |
| 5 | Strip Dry Film | | |

**Table 3: Processing of Materials (Bottom Portion Material 2)**

| Step | Type | Description | Note |
|---|---|---|---|
| 1 | Dry Film Conductive Layers | | |
| 2 | Expose | Mask Material 2 (Upper Conductive Layer) | Forms Ground Plane on Upper Conductive Layer |
| 3 | Develop | | |
| 4 | Etch Cu | | No Etching on Lower Conductive Layer |
| 5 | Strip Dry Film | | |

**Table 4: Processing of Materials 1,2, and 3 (Form Bottom Portion)**

| Step | Type | Description | Note |
|---|---|---|---|
| 1 | Laminate | Materials 1 and 2 Laminated Using Material 3 | |
| 2 | Drill Thru Holes | Drill Bit = 0.025 in. | |
| 3 | Direct Metallization/Flash Copper | Plates Thru Holes | |
| 4 | Dry Film (L1 and L4) | | |
| 5 | Expose | Mask Laminated Materials 1 and 2 (Upper and Lower Conductive Layers) | Forms Traces and Solder Pads |
| 6 | Develop | | |
| 7 | Electrolytic Cu | 1.0 mil | |
| 8 | Electrolytic Sn | As Required | |
| 9 | Strip Dry Film | | |
| 10 | Etch Cu | | |
| 11 | Etch Sn | | |
| 12 | Insert Finishing Option Here | NG Option (See Table Below) | NG Option for Proof of Principle |
| 13 | Dry Film (cover lay) on Upper Conductive Layer Only | 2.5 mil | Minimum Thickness on Upper Conductive Layer |
| 14 | Expose | Mask Laminated Materials 1 and 2 (upper and lower) | This mask defines an area on the upper conductive layer that will receive a dry film solder mask (cover lay). The bottom layer will not have dry film applied to it The plated through holes will be bridged over by the coating on the top. |
| 15 | Develop | | |
| 16 | Cure | | Full Cure |
| 17 | Route Panels | Route Bit = As Required | Forms 4" x 4" pieces. Conforms to finished dims |

Table 5 describes the formation of the side portion 52. This process involves routing a matrix of openings in FR-4 board. However, punching is thought to be the cost effective method for manufacturing. The punching may done by punching through the entire core, or, alternatively, punching several layers of no-flow pre-preg and thin core c-stage which are then laminated to form the wall of proper thickness.

After routing the matrix, the board will have to be electroless or DM plated. Finally, the boards will have to be routed to match the bottom portion. This step can be done first or last. It may make the piece more workable to perform the final routing as a first step.

**Table 5: Processing of Material 4 (Side Portion)**

| Step | Type | Description | Note |
|---|---|---|---|
| 1 | Route/Punch Matric of Openings | Route Bit = 0.031 in. | Forms Side Portion |
| 2 | Direct Metallization/Flash Cu | 0.25 mil minimum | Forms Sidewalls on Side Portion |
| 3 | Route Panels | | |

Table 6 describes the processing of the top portion. The formation of the top portion 48 involves imaging a dry film cover lay or liquid solder mask on the bottom (i.e. conductive layer forming the inner layer. The exposed layer of the top portion 48 will not have a copper coating. It can be processed this way through etching or purchased this way as a one sided laminate.

A matrix of holes is drilled into the lid board. Drilling may occur after the imaging step. If so, then a suitable solder mask must be chosen that can survive the drilling process.

**Table 6: Processing of Top Portion**

| Step | Type | Description | Note |
|---|---|---|---|
| 1 | Dry Film | Conductive Layer | |
| 2 | Expose | Mask Bare Layer | Form Conduction Ring |
| 3 | Develop | | |
| 4 | Cure | | |
| 5 | Drill Matrix of Holes | Drill Bit = 0.025 in. | Acoustic Ports |
| 6 | Laminate | PTFE (Environmental Barrier) Between 2 Pieces of Material 5 | Forms Top Portion |

**Table 7: Processing of Laminated Materials 1 and 2 with Material 4**

| Step | Type | Description | Note |
|---|---|---|---|
| 1 | Screen Conductive Adhesive on Material 4 | | |
| 2 | Laminate | Bottom Portion with Side Portion | Forms Bottom Portion with Side Portion (spacer) |
| 3 | Add Transducer Assembly | Silicon Die Microphone and Integrated Circuit | |

**Table 8: Processing of Laminated Materials 1, 2, and 4 with Material 5**

| Step | Type | Description | Note |
|---|---|---|---|
| 1 | Screen Conductive Adhesive on Top Portion | | |
| 2 | Laminate | Bottom Portion and Side Portion with Top Portion | Forms Housing |
| 3 | Dice | | |

**Table 9: Finishing Option NG (Nickel/Gold)**

| Step | Type | Description | Note |
|---|---|---|---|
| 1 | Immersion Ni (40-50 *µ*-in) | | |
| 2 | Immersion Au (25-30 *µ*-in) | | |

**Table 10: Finishing Option NGT (Nickel/Gold/Tin)**

| Step | Type |
|---|---|
| 1 | Mask L2 (using thick dry film or high tack dicing tape) |
| 2 | Immersion Ni (40-50 *µ*-in) |
| 3 | Immersion Au (25-30 *µ*-in) |
| 4 | Remove Mask on L2 |
| 5 | Mask L1 (using thick dry film or high tack dicing tape) bridge over cavity created by wall |
| 6 | Immersion Sn (100-250 *µ*-in) |
| 7 | Remove Mask on L1 |

**Table 11: Finishing Option ST (Silver/Tin)**

| Step | Type |
|---|---|
| 1 | Mask L2 (using thick dry film or high tack dicing tape) |
| 2 | Immersion Ag (40-50 *µ*-in) |
| 3 | Remove Mask on L2 |
| 4 | Mask L1 (using thick dry film or high tack dicing tape) bridge over cavity created by wall |
| 5 | Immersion Sn (100-250 *µ*-in) |
| 6 | Remove Mask on L1 |

While specific embodiments have been illustrated and described, numerous modifications come to mind without departing the scope of protection of the accompanying Claims.

## Claims

1. A silicon condenser microphone package (40) for containing a silicon condenser microphone transducer (58), the silicon condenser microphone transducer (58) being responsive to sound pressure levels of an acoustic signal to provide an electrical output representative of the acoustic signals, the silicon condenser microphone package (40) **characterized in that**:
at least a first, top member (48) and a second, bottom member (50) and a chamber (56) being defined by the first, top member (48) and the second, bottom member (50), the silicon condenser microphone transducer (58) being attached to a surface formed on one of the first, top member (48) or the second, bottom member (50) and the silicon condenser microphone transducer (58) residing within the chamber (56);
the one of first, top member (48) or second, bottom member (50) which has the surface being formed with at least one patterned conductive layer (44), the patterned conductive layer (44) being electrically coupled to the silicon condenser microphone transducer (58);
an outside surface of the silicon condenser microphone package (40) comprising a plurality of terminal pads electrically coupled to the patterned conductive layer (44);
a volume associated with the silicon condenser microphone transducer and one of the first, top member (48) or the second, bottom member (50), the volume being acoustically coupled to the silicon condenser microphone transducer (58); and
one of the first, top member (48) or the second, bottom member (50) being formed to include an aperture (54), the aperture (54) being suitable to permit the passage of an acoustic signal to the silicon condenser microphone transducer (58).

2. The silicon condenser microphone package (40) of claim 1, wherein the first, top member (48) comprises a substrate and the second, bottom member (50) comprises a cover coupled to the substrate to define the chamber (56).

3. The silicon condenser microphone package (40) of claim 1, the volume including a portion of aperture (54).

4. The silicon condenser microphone package (40) of claim 1, the volume including a recess formed in one of the first, top member (48) or the second, bottom member (50).

5. The silicon condenser microphone package (40) of claim 1, the volume including a hole through one of the first, top member (48) or the second, bottom member (50).

6. The silicon condenser microphone package (40) of claim 1, the silicon condenser microphone package (40) being secured to a substrate of a device, the chamber (56) in communication with a cavity formed in the device substrate.

7. The silicon condenser microphone package (40) of claim 1, the aperture (54) being acoustically coupled to a first side of the silicon condenser microphone transducer (58) and the volume being acoustically coupled to a second side of the silicon condenser microphone transducer (58).

8. The silicon condenser microphone package of (40) claim 1, the aperture (54) being formed in the first, top member (48), the surface being formed on the first, top member (48) and the silicon condenser microphone transducer (58) being attached to the surface completely covering the aperture (54).

9. The silicon condenser microphone package (40) of claim 1, the aperture (54) being formed in the first, top member (48), the surface being formed on the first, top member (48) and the silicon condenser microphone transducer (58) being attached to the surface adjacent to the aperture (54).

10. The silicon condenser microphone package (40) of claim 1, the aperture (54) being formed in the second, bottom member (50), the surface being formed on the first, top member (48) and the aperture (54) is acoustically coupled by the chamber (56) to the silicon condenser microphone transducer (58).

11. The silicon condenser microphone package (40) of claim 1, the aperture (54) is formed in the first, top member (48), the surface is formed on the first, top member (48) and the silicon condenser microphone transducer (58) is attached to the surface leaving the aperture (54) uncovered by the silicon condenser microphone transducer (58), wherein the aperture (54) is coupled to the silicon condenser microphone transducer (58) via the chamber (56).

12. The silicon condenser microphone package (40) of claim 1, the aperture (54) is formed in each of the first, top member (48) and the second, bottom member (50).

13. The silicon condenser microphone package (40) of claim 1, the aperture (54) is formed in the second, bottom member (50), the surface is formed on the first, top member (48) and the aperture (54) is coupled to the silicon condenser microphone transducer (58) via the chamber (56), and the volume includes a recess formed in the first, top member (48).

14. The silicon condenser microphone package (40) of claim 1, the aperture (54) is formed in the first, top member (48), the surface is formed on the first, top member (48) and the silicon condenser microphone transducer (58) is attached to the surface covering the aperture (54) and a sealing ring (22) is disposed about and surrounding the aperture (54), the sealing ring (22) providing a seal between the silicon condenser microphone transducer (58) and the surface.

15. The silicon condenser microphone package (40) of claim 1, the silicon condenser microphone package (40) being secured to a surface of a device, a sealing ring (22) disposed about and surrounding the aperture (54) on an outside surface of the silicon condenser microphone package (40), the sealing ring (22) providing a seal between the silicon condenser microphone package (40) and the surface of the device.

16. The silicon condenser microphone package (40) of claim 1, the patterned conductive layer (44) comprising a plurality of terminal pads, the terminal pads providing an electrical connection between the silicon condenser microphone transducer (58) within the volume and an exterior of the silicon condenser microphone package (40).

17. The silicon condenser microphone package (40) of claim 1, a metalized region (70) being formed on an exterior surface of the silicon condenser microphone package (40), the metalized region (70) being electrically coupled to the patterned conductive layer (44).

18. The silicon condenser microphone package (40) of claim 1, one or both of the first, top member (48) and the second, bottom member (50) including a shield against electromagnetic interference.

19. The silicon condenser microphone package (40) of claim 1, the first, top member (48) and the second, bottom member (50) each comprising alternating conductive and non-conductive layers.

20. The silicon condenser microphone package (40) of claim 1, the first, top member (48) comprising a printed circuit board.

21. The silicon condenser microphone package (40) of claim 1, a third, spacer member (65) being disposed between the first, top member (48) and the second, bottom member (50), the first, top member (48), the second, bottom member (50) and the third, spacer member (65) defining the chamber (56).

22. The silicon condenser microphone package (40) of claim 1, a barrier (62) being disposed within the aperture (54).

23. The silicon condenser microphone package (40) of claim 22, wherein the barrier (22) has acoustic properties.

24. The silicon condenser microphone package (40) of claim 23, wherein the barrier (22) forms an environmental protective barrier.

25. The silicon condenser microphone package (40) of claim 1, the aperture (54) being formed in the second, bottom member (50), the surface being formed on the first, top member (48), the aperture (54) being coupled to the silicon condenser microphone transducer (58) via the chamber (56) and a passage being formed in the first, top member (48), the passage being coupled to the silicon condenser microphone transducer (58).

26. The silicon condenser microphone package (40) of claim 25, wherein the passage comprises a portion of an acoustic port.

27. The silicon condenser microphone package (40) of claim 26, wherein a barrier (62) is disposed within the passage.

28. The silicon condenser microphone package (40) of claim 1, wherein the volume includes a portion of the chamber (56).

29. The silicon condenser microphone package (40) of claim 1, wherein the acoustic signal is coupled to the silicon condenser microphone transducer (58) via the chamber (56).

30. The silicon condenser microphone package (40) of claim 1, comprising a retaining ring (84) disposed adjacent the silicon condenser microphone transducer (58) to prevent wicking of a securing epoxy into the transducer (58) or the aperture (54).

31. The silicon condenser microphone package (40) of claim 30, wherein the retaining ring (84) comprises a conductive material imaged onto a non-conductive portion of the surface.

32. The silicon condenser microphone package (40) of claim 30, wherein the silicon condenser microphone transducer (58) has a footprint and wherein the retaining ring (84) has a shape substantially matching the footprint.

33. The silicon condenser microphone package (40) of claim 30, wherein the retaining ring (84) is sized to fit within the footprint of the silicon condenser microphone transducer (58).

34. The silicon condenser microphone package (40) of claim 30, wherein the silicon condenser microphone transducer (58) contacts the retaining ring (84).

35. The silicon condenser microphone package (40) of claim 30, wherein the retaining ring (84) contacts an etched port of the silicon condenser microphone transducer (58).

## Patentansprüche

1. Siliziumkondensatormikrofongehäuse (40) zum Aufnehmen eines Siliziumkondensatormikrofonwandlers (58), wobei der Siliziumkondensatormikrofonwandler (58) auf Schalldruckpegel eines akustischen Signals reagiert und ein elektrisches Ausgangssignal bereitstellt, das für die akustischen Signale repräsentativ ist, wobei das Siliziumkondensatormikrofongehäuse (40) **gekennzeichnet ist durch** bzw. **dadurch** gekennzeichnet ist, dass:
mindestens ein erstes, oberes Element (48) und ein zweites, unteres Element (50) und eine Kammer (56), die **durch** das erste, obere Element (48) und das zweite, untere Element (50) festgelegt ist, wobei der Siliziumkondensatormikrofonwandler (58) an einer Oberfläche angebracht ist, die auf einem des ersten, oberen Elements (48) oder des zweiten, unteren Elements (50) angebracht ist und der Siliziumkondensatormikrofonwandler (58) innerhalb der Kammer (56) vorliegt,
das eine des ersten, oberen Elements (48) oder des zweiten, unteren Elements (50) eine Oberfläche aufweist, die mit mindestens einer strukturierten leitenden Schicht (44) ausgebildet ist, wobei die strukturierte leitende Schicht (44) elektrisch mit dem Siliziumkondensatormikrofonwandler (58) gekoppelt ist,
eine Außenoberfläche des Siliziumkondensatormikrofongehäuses (40) eine Mehrzahl von Kontaktstellen umfasst, die elektrisch mit der strukturierten leitenden Schicht (44) gekoppelt sind,
ein Volumen, das dem Siliziumkondensatormikrofonwandler und einem des ersten, oberen Elements (48) oder des zweiten, unteren Elements (50) zugeordnet ist, wobei das Volumen akustisch mit dem Siliziumkondensatormikrofonwandler (58) gekoppelt ist, und
eines des ersten, oberen Elements (48) oder des zweiten, unteren Elements (50) so ausgebildet ist, dass es eine Öffnung (54) umfasst, wobei die Öffnung (54) dazu geeignet ist, den Durchgang eines akustischen Signals zu dem Siliziumkondensatormikrofonwandler (58) zuzulassen.

2. Siliziumkondensatormikrofongehäuse (40) nach Anspruch 1, bei dem das erste, obere Element (48) ein Substrat umfasst und das zweite, untere Element (50) eine Abdeckung umfasst, die mit dem Substrat gekoppelt ist, so dass die Kammer (56) festgelegt ist.

3. Siliziumkondensatormikrofongehäuse (40) nach Anspruch 1, bei dem das Volumen einen Abschnitt der Öffnung (54) umfasst.

4. Siliziumkondensatormikrofongehäuse (40) nach Anspruch 1, bei dem das Volumen eine Aussparung umfasst, die in einem des ersten, oberen Elements (48) oder des zweiten, unteren Elements (50) ausgebildet ist.

5. Siliziumkondensatormikrofongehäuse (40) nach Anspruch 1, bei dem das Volumen ein Loch durch eines des ersten, oberen Elements (48) oder des zweiten, unteren Elements (50) umfasst.

6. Siliziumkondensatormikrofongehäuse (40) nach Anspruch 1, wobei das Siliziumkondensatormikrofongehäuse (40) an einem Substrat einer Vorrichtung angebracht ist, wobei die Kammer (56) mit einem in dem Vorrichtungssubstrat ausgebildeten Hohlraum in Verbindung steht.

7. Siliziumkondensatormikrofongehäuse (40) nach Anspruch 1, bei dem die Öffnung (54) akustisch mit einer ersten Seite des Siliziumkondensatormikrofonwandlers (58) gekoppelt ist und das Volumen akustisch mit einer zweiten Seite des Siliziumkondensatormikrofonwandlers (58) gekoppelt ist.

8. Siliziumkondensatormikrofongehäuse (40) nach Anspruch 1, bei dem die Öffnung (54) in dem ersten, oberen Element (48) ausgebildet ist, wobei die Oberfläche auf dem ersten, oberen Element (48) ausgebildet ist und der Siliziumkondensatormikrofonwandler (58) an der Oberfläche angebracht ist und die Öffnung (54) vollständig bedeckt.

9. Siliziumkondensatormikrofongehäuse (40) nach Anspruch 1, bei dem die Öffnung (54) in dem ersten, oberen Element (48) ausgebildet ist, wobei die Oberfläche auf dem ersten, oberen Element (48) ausgebildet ist und der Siliziumkondensatormikrofonwandler (58) an der Oberfläche angrenzend an die Öffnung (54) angebracht ist.

10. Siliziumkondensatormikrofongehäuse (40) nach Anspruch 1, bei dem die Öffnung (54) in dem zweiten, unteren Element (50) ausgebildet ist, wobei die Oberfläche auf dem ersten, oberen Element (48) ausgebildet ist und die Öffnung (54) mittels der Kammer (56) akustisch mit dem Siliziumkondensatormikrofonwandler (58) gekoppelt ist.

11. Siliziumkondensatormikrofongehäuse (40) nach Anspruch 1, bei dem die Öffnung (54) in dem ersten, oberen Element (48) ausgebildet ist, wobei die Oberfläche auf dem ersten, oberen Element (48) ausgebildet ist und der Siliziumkondensatormikrofonwandler (58) an der Oberfläche angebracht ist, wobei die Öffnung (54) nicht durch den Siliziumkondensatormikrofonwandler (58) bedeckt ist, wobei die Öffnung (54) mittels der Kammer (56) mit dem Siliziumkondensatormikrofonwandler (58) gekoppelt ist.

12. Siliziumkondensatormikrofongehäuse (40) nach Anspruch 1, bei dem die Öffnung (54) in jedem des ersten, oberen Elements (48) und des zweiten, unteren Elements (50) ausgebildet ist.

13. Siliziumkondensatormikrofongehäuse (40) nach Anspruch 1, bei dem die Öffnung (54) in dem zweiten, unteren Element (50) ausgebildet ist, wobei die Oberfläche auf dem ersten, oberen Element (48) ausgebildet ist und die Öffnung (54) mittels der Kammer (56) mit dem Siliziumkondensatormikrofonwandler (58) gekoppelt ist, und das Volumen eine Aussparung umfasst, die in dem ersten, oberen Element (48) ausgebildet ist.

14. Siliziumkondensatormikrofongehäuse (40) nach Anspruch 1, bei dem die Öffnung (54) in dem ersten, oberen Element (48) ausgebildet ist, wobei die Oberfläche auf dem ersten, oberen Element (48) ausgebildet ist und der Siliziumkondensatormikrofonwandler (58) an der Oberfläche angebracht ist und die Öffnung (54) bedeckt, und ein Dichtungsring (22) um die Öffnung (54) angeordnet ist und diese umgibt, wobei der Dichtungsring (22) eine Abdichtung zwischen dem Siliziumkondensatormikrofonwandler (58) und der Oberfläche bereitstellt.

15. Siliziumkondensatormikrofongehäuse (40) nach Anspruch 1, wobei das Siliziumkondensatormikrofongehäuse (40) an einer Oberfläche einer Vorrichtung angebracht ist, wobei ein Dichtungsring (22) auf einer Außenoberfläche des Siliziumkondensatormikrofongehäuses (40) um die Öffnung (54) angeordnet ist und diese umgibt, wobei der Dichtungsring (22) eine Abdichtung zwischen dem Siliziumkondensatormikrofongehäuse (40) und der Oberfläche der Vorrichtung bereitstellt.

16. Siliziumkondensatormikrofongehäuse (40) nach Anspruch 1, bei dem die strukturierte leitende Schicht (44) eine Mehrzahl von Kontaktstellen umfasst, wobei die Kontaktstellen eine elektrische Verbindung zwischen dem Siliziumkondensatormikrofonwandler (58) innerhalb des Volumens und einem Äußeren des Siliziumkondensatormikrofongehäuses (40) bereitstellen.

17. Siliziumkondensatormikrofongehäuse (40) nach Anspruch 1, wobei ein metallisierter Bereich (70) auf einer Außenoberfläche des Siliziumkondensatormikrofongehäuses (40) ausgebildet ist, wobei der metallisierte Bereich (70) elektrisch mit der strukturierten leitenden Schicht (44) verbunden ist.

18. Siliziumkondensatormikrofongehäuse (40) nach Anspruch 1, bei dem eines oder beide des ersten, oberen Elements (48) und des zweiten, unteren Elements (50) eine Abschirmung gegen eine elektromagnetische Störung umfasst oder umfassen.

19. Siliziumkondensatormikrofongehäuse (40) nach Anspruch 1, bei dem das erste, obere Element (48) und das zweite, untere Element (50) jeweils abwechselnde leitende und nicht-leitende Schichten umfassen.

20. Siliziumkondensatormikrofongehäuse (40) nach Anspruch 1, bei dem das erste, obere Element (48) eine gedruckte Schaltung umfasst.

21. Siliziumkondensatormikrofongehäuse (40) nach Anspruch 1, bei dem ein drittes Abstandshalterelement (65) zwischen dem ersten, oberen Element (48) und dem zweiten, unteren Element (50) angeordnet ist und das erste, obere Element (48), das zweite, untere Element (50) und das dritte Abstandshalterelement (65) die Kammer (56) festlegen.

22. Siliziumkondensatormikrofongehäuse (40) nach Anspruch 1, bei dem eine Barriere (62) innerhalb der Öffnung (54) angeordnet ist.

23. Siliziumkondensatormikrofongehäuse (40) nach Anspruch 22, bei dem die Barriere (22) akustische Eigenschaften aufweist.

24. Siliziumkondensatormikrofongehäuse (40) nach Anspruch 23, bei dem die Barriere (22) eine Umgebungsschutzbarriere bildet.

25. Siliziumkondensatormikrofongehäuse (40) nach Anspruch 1, bei dem die Öffnung (54) in dem zweiten, unteren Element (50) ausgebildet ist, wobei die Oberfläche auf dem ersten, oberen Element (48) ausgebildet ist, wobei die Öffnung (54) mittels der Kammer (56) mit dem Siliziumkondensatormikrofonwandler (58) gekoppelt ist und ein Durchgang in dem ersten, oberen Element (48) ausgebildet ist, wobei der Durchgang mit dem Siliziumkondensatormikrofonwandler (58) gekoppelt ist.

26. Siliziumkondensatormikrofongehäuse (40) nach Anspruch 25, bei dem der Durchgang einen Abschnitt einer akustischen Öffnung umfasst.

27. Siliziumkondensatormikrofongehäuse (40) nach Anspruch 26, bei dem eine Barriere (62) innerhalb des Durchgangs angeordnet ist.

28. Siliziumkondensatormikrofongehäuse (40) nach Anspruch 1, bei dem das Volumen einen Abschnitt der Kammer (56) umfasst.

29. Siliziumkondensatormikrofongehäuse (40) nach Anspruch 1, bei dem das akustische Signal mittels der Kammer (56) mit dem Siliziumkondensatormikrofonwandler (58) gekoppelt ist.

30. Siliziumkondensatormikrofongehäuse (40) nach Anspruch 1, das einen Haltering (84) umfasst, der angrenzend an den Siliziumkondensatormikrofonwandler (58) angeordnet ist, so dass ein Ansaugen eines Anbringungsepoxyharzes in den Wandler (58) oder die Öffnung (54) verhindert wird.

31. Siliziumkondensatormikrofongehäuse (40) nach Anspruch 30, bei dem der Haltering (84) ein leitendes Material umfasst, das auf einem nicht-leitenden Abschnitt der Oberfläche aufgebracht ist.

32. Siliziumkondensatormikrofongehäuse (40) nach Anspruch 30, bei dem der Siliziumkondensatormikrofonwandler (58) eine Montagefläche aufweist und bei dem der Haltering (84) eine Gestalt aufweist, die im Wesentlichen mit der Montagefläche übereinstimmt.

33. Siliziumkondensatormikrofongehäuse (40) nach Anspruch 30, bei dem der Haltering (84) eine Größe aufweist, die derart ist, dass sie in die Montagefläche des Siliziumkondensatormikrofonwandlers (58) passt.

34. Siliziumkondensatormikrofongehäuse (40) nach Anspruch 30, bei dem der Siliziumkondensatormikrofonwandler (58) den Haltering (84) kontaktiert.

35. Siliziumkondensatormikrofongehäuse (40) nach Anspruch 30, bei dem der Haltering (84) eine geätzte Öffnung des Siliziumkondensatormikrofonwandlers (58) kontaktiert.

## Revendications

1. Boîtier de microphone à condensateur en silicium (40) pour contenir un transducteur de microphone à condensateur en silicium (58), le transducteur de microphone à condensateur en silicium (58) étant sensible à des niveaux de pression sonore d'un signal acoustique pour fournir une sortie électrique représentative des signaux acoustiques, le boîtier de microphone à condensateur en silicium (40) étant **caractérisé par le fait que** :
au moins un premier élément, supérieur, (48) et un deuxième élément, inférieur, (50) et une chambre (56) définie par le premier élément supérieur (48) et le deuxième élément inférieur (50), le transducteur de microphone à condensateur en silicium (58) étant fixé à une surface formée sur l'un parmi le premier élément supérieur (48) et le deuxième élément inférieur (50) et le transducteur de microphone à condensateur en silicium (58) se trouvant à l'intérieur de la chambre (56) ;
celui parmi le premier élément supérieur (48) et le deuxième élément inférieur (50) qui possède la surface étant formé avec au moins une couche conductrice à motifs (44), la couche conductrice à motifs (44) étant couplée électriquement au transducteur de microphone à condensateur en silicium (58) ;
une surface extérieure du boîtier de microphone à condensateur en silicium (40) comprenant une pluralité de plots de borne couplés électriquement à la couche conductrice à motifs (44) ;
un volume associé au transducteur de microphone à condensateur en silicium et l'un parmi le premier élément supérieur (48) et le deuxième élément inférieur (50), le volume étant couplé acoustiquement au transducteur de microphone à condensateur en silicium (58) ; et
l'un parmi le premier élément supérieur (48) et le deuxième élément inférieur (50) étant formé pour inclure une ouverture (54), l'ouverture (54) étant appropriée pour permettre le passage d'un signal acoustique vers le transducteur de microphone à condensateur en silicium (58).

2. Boîtier de microphone à condensateur en silicium (40) selon la revendication 1, dans lequel le premier élément supérieur (48) comprend un substrat et le deuxième élément inférieur (50) comprend un couvercle couplé au substrat pour définir la chambre (56).

3. Boîtier de microphone à condensateur en silicium (40) selon la revendication 1, le volume comprenant une partie de l'ouverture (54).

4. Boîtier de microphone à condensateur en silicium (40) selon la revendication 1, le volume comprenant un évidement formé dans l'un parmi le premier élément supérieur (48) et le deuxième élément inférieur (50).

5. Boîtier de microphone à condensateur en silicium (40) selon la revendication 1, le volume comprenant un trou à travers l'un parmi le premier élément supérieur (48) et le deuxième élément inférieur (50).

6. Boîtier de microphone à condensateur en silicium (40) selon la revendication 1, le boîtier de microphone à condensateur en silicium (40) étant fixé à un substrat d'un dispositif, la chambre (56) étant en communication avec une cavité formée dans le substrat de dispositif.

7. Boîtier de microphone à condensateur en silicium (40) selon la revendication 1, l'ouverture (54) étant couplée acoustiquement à un premier côté du transducteur de microphone à condensateur en silicium (58) et le volume étant couplé acoustiquement à un second côté du transducteur de microphone à condensateur en silicium (58).

8. Boîtier de microphone à condensateur en silicium (40) selon la revendication 1, l'ouverture (54) étant formée dans le premier élément supérieur (48), la surface étant formée sur le premier élément supérieur (48) et le transducteur de microphone à condensateur en silicium (58) étant fixé à la surface, recouvrant entièrement l'ouverture (54).

9. Boîtier de microphone à condensateur en silicium (40) selon la revendication 1, l'ouverture (54) étant formée dans le premier élément supérieur (48), la surface étant formée sur le premier élément supérieur (48) et le transducteur de microphone à condensateur en silicium (58) étant fixé à la surface, adjacent à l'ouverture (54).

10. Boîtier de microphone à condensateur en silicium (40) selon la revendication 1, l'ouverture (54) étant formée dans le deuxième élément inférieur (50), la surface étant formée sur le premier élément supérieur (48) et l'ouverture (54) étant couplée acoustiquement par la chambre (56) au transducteur de microphone à condensateur en silicium (58).

11. Boîtier de microphone à condensateur en silicium (40) selon la revendication 1, l'ouverture (54) étant formée dans le premier élément supérieur (48), la surface étant formée sur le premier élément supérieur (48) et le transducteur de microphone à condensateur en silicium (58) étant fixé à la surface, laissant l'ouverture (54) exposée par le transducteur de microphone à condensateur en silicium (58), l'ouverture (54) étant couplée au transducteur de microphone à condensateur en silicium (58) par l'intermédiaire de la chambre (56).

12. Boîtier de microphone à condensateur en silicium (40) selon la revendication 1, l'ouverture (54) étant formée dans chacun du premier élément supérieur (48) et du deuxième élément inférieur (50).

13. Boîtier de microphone à condensateur en silicium (40) selon la revendication 1, l'ouverture (54) étant formée dans le deuxième élément inférieur (50), la surface étant formée sur le premier élément supérieur (48) et l'ouverture (54) étant couplée au transducteur de microphone à condensateur en silicium (58) par l'intermédiaire de la chambre (56), et le volume comporte un évidement formé dans le premier élément supérieur (48).

14. Boîtier de microphone à condensateur en silicium (40) selon la revendication 1, l'ouverture (54) étant formée dans le premier élément supérieur (48), la surface étant formée sur le premier élément supérieur (48) et le transducteur de microphone à condensateur en silicium (58) étant fixé à la surface, recouvrant l'ouverture (54), et une bague d'étanchéité (22) étant disposée autour de et entourant l'ouverture (54), la bague d'étanchéité (22) fournissant une étanchéité entre le transducteur de microphone à condensateur en silicium (58) et la surface.

15. Boîtier de microphone à condensateur en silicium (40) selon la revendication 1, le boîtier de microphone à condensateur en silicium (40) étant fixé à une surface d'un dispositif, une bague d'étanchéité (22) étant disposée autour de et entourant l'ouverture (54) sur une surface extérieure du boîtier de microphone à condensateur en silicium (40), la bague d'étanchéité (22) fournissant une étanchéité entre le boîtier de microphone à condensateur en silicium (40) et la surface du dispositif.

16. Boîtier de microphone à condensateur en silicium (40) selon la revendication 1, la couche conductrice à motifs (44) comprend une pluralité de plots de borne, les plots de borne fournissant une connexion électrique entre le transducteur de microphone à condensateur en silicium (58) à l'intérieur du volume et un extérieur du boîtier de microphone à condensateur en silicium (40).

17. Boîtier de microphone à condensateur en silicium (40) selon la revendication 1, une région métallisée (70) étant formée sur une surface extérieure du boîtier de microphone à condensateur en silicium (40), la région métallisée (70) étant couplée électriquement à la couche conductrice à motifs (44).

18. Boîtier de microphone à condensateur en silicium (40) selon la revendication 1, l'un ou les deux parmi le premier élément supérieur (48) et le deuxième élément inférieur (50) comprenant une protection contre les interférences électromagnétiques.

19. Boîtier de microphone à condensateur en silicium (40) selon la revendication 1, le premier élément supérieur (48) et le deuxième élément inférieur (50) comprenant chacun des couches conductrices et non-conductrices alternées.

20. Boîtier de microphone à condensateur en silicium (40) selon la revendication 1, le premier élément supérieur (48) comprenant une carte de circuit imprimé.

21. Boîtier de microphone à condensateur en silicium (40) selon la revendication 1, un troisième élément, d'espacement, (65) étant disposé entre le premier élément supérieur (48) et le deuxième élément inférieur (50), le premier élément supérieur (48), le deuxième élément inférieur (50) et le troisième élément d'espacement (65) définissant la chambre (56).

22. Boîtier de microphone à condensateur en silicium (40) selon la revendication 1, une barrière (62) étant disposée à l'intérieur de l'ouverture (54).

23. Boîtier de microphone à condensateur en silicium (40) selon la revendication 22, dans lequel la barrière (22) possède des propriétés acoustiques.

24. Boîtier de microphone à condensateur en silicium (40) selon la revendication 23, dans lequel la barrière (22) forme une barrière de protection environnementale.

25. Boîtier de microphone à condensateur en silicium (40) selon la revendication 1, l'ouverture (54) étant formée dans le deuxième élément inférieur (50), la surface étant formée sur le premier élément supérieur (48), l'ouverture (24) étant couplée au transducteur de microphone à condensateur en silicium (58) par l'intermédiaire de la chambre (56) et un passage étant formé dans le premier élément supérieur (48), le passage étant couplé au transducteur de microphone à condensateur en silicium (58).

26. Boîtier de microphone à condensateur en silicium (40) selon la revendication 25, dans lequel le passage comprend une partie d'un orifice acoustique.

27. Boîtier de microphone à condensateur en silicium (40) selon la revendication 26, dans lequel une barrière (62) est disposée à l'intérieur du passage.

28. Boîtier de microphone à condensateur en silicium (40) selon la revendication 1, dans lequel le volume comprend une partie de la chambre (56).

29. Boîtier de microphone à condensateur en silicium (40) selon la revendication 1, dans lequel le signal acoustique est couplé au transducteur de microphone à condensateur en silicium (58) par l'intermédiaire de la chambre (56).

30. Boîtier de microphone à condensateur en silicium (40) selon la revendication 1, comprenant une bague de retenue (84) disposée adjacente au transducteur de microphone à condensateur en silicium (58) pour empêcher l'effet de mèche d'un époxy de fixation dans le transducteur (58) ou l'ouverture (54).

31. Boîtier de microphone à condensateur en silicium (40) selon la revendication 30, dans lequel la bague de retenue (84) comprend un matériau conducteur imagé sur une partie non-conductrice de la surface.

32. Boîtier de microphone à condensateur en silicium (40) selon la revendication 30, dans lequel le transducteur de microphone à condensateur en silicium (58) a un encombrement et la bague de retenue (84) a une forme correspondant sensiblement à l'encombrement.

33. Boîtier de microphone à condensateur en silicium (40) selon la revendication 30, dans lequel la bague de retenue (84) est dimensionnée pour s'ajuster dans l'encombrement du transducteur de microphone à condensateur en silicium (58).

34. Boîtier de microphone à condensateur en silicium (40) selon la revendication 30, dans lequel le transducteur de microphone à condensateur en silicium (58) est en contact avec la bague de retenue (84).

35. Boîtier de microphone à condensateur en silicium (40) selon la revendication 30, dans lequel la bague de retenue (84) est en contact avec un orifice gravé du transducteur de microphone à condensateur en silicium (58).
